# EUROPEAN PATENT SPECIFICATION

(11) **EP 4 513 531 B1**
(45) Date of publication and mention of the grant of the patent: **01.10.2025**
(21) Application number: 23192410.1
(22) Date of filing: 21.08.2023
(51) Int. Cl.: H01L 21/50, H01L 23/04, H01L 23/10, H01L 23/498, H01L 25/07, H01L 23/053, H01L 23/24, H01L 23/373

(54) **HOUSING, SEMICONDUCTOR MODULE COMPRISING A HOUSING, AND METHOD FOR ASSEMBLING A SEMICONDUCTOR MODULE**
GEHÄUSE, HALBLEITERMODUL MIT EINEM GEHÄUSE UND VERFAHREN ZUR MONTAGE EINES HALBLEITERMODULS
BOÎTIER, MODULE SEMI-CONDUCTEUR COMPRENANT UN BOÎTIER ET PROCÉDÉ D'ASSEMBLAGE D'UN MODULE SEMI-CONDUCTEUR

(43) Date of publication of application: 26.02.2025
(60) Divisional application: 25177943.5
(73) Proprietor: Infineon Technologies AG, 85579 Neubiberg (DE)
(72) Inventor: LUDWIG, Marco, 58739 Wickede/ Ruhr (DE); TSCHIRBS, Roman, 59494 Soest (DE)
(74) Representative: Westphal, Mussgnug & Partner, Patentanwälte mbB

(56) References cited:
- US-A1- 2017 339 798
- US-A1- 2020 161 145
- US-A1- 2022 029 519
- US-B2- 9 041 196

## Description

### TECHNICAL FIELD

The instant disclosure relates to a housing, a semiconductor module comprising a housing, and a method for assembling a semiconductor module.

### BACKGROUND

Document US 2022/029519 A1 discloses a power conversion module including a motherboard having a first surface and a second surface that opposes the first surface. The motherboard includes a first trace that electrically couples a decoupling capacitor mounted on the motherboard to a first pad on the first surface of the motherboard and an output node of a power conversion module. The motherboard includes a via extending through the motherboard that electrically couples a second pad on the first surface of the motherboard and a third pad on the second surface of the motherboard to the output node and a second trace that electrically couples a fourth pad on the second surface of the motherboard and the decoupling capacitor. The power module includes a first daughterboard mounted on the first surface of the motherboard and a second daughterboard mounted on the second surface of the motherboard.

Document US 2017/339798 A1 discloses a power module including a substrate and a modular housing structure. The substrate includes an electronic element disposed thereon. The modular housing structure is disposed on the substrate and located around the electronic element. The modular housing structure includes a plurality of sidewalls configured to connect with each other detachably. Each sidewall includes two connecting elements disposed on two opposite ends thereof respectively. The two connecting elements of any one of the sidewalls are connected to two corresponding connecting elements of two adjacent sidewalls respectively. Consequently, the numbers and connections of the sidewalls are adjustable and varied according to the size of the substrate.

Power semiconductor module arrangements often include at least one substrate arranged in a housing. A semiconductor arrangement including a plurality of controllable semiconductor elements (e.g., two IGBTs in a half-bridge configuration) or non-controllable semiconductor elements (e.g., arrangements of diodes) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate.

The housing may be glued to the substrate. Gluing the housing to the substrate, however, requires pretreatment steps (e.g., a plasma treatment of the substrate), a step in which the glue is applied to the substrate, as well as a hardening step in which the originally viscous glue is hardened, thereby permanently attaching the housing to the substrate. Each additional step during the assembly process requires additional process time and increases the overall cost of the power semiconductor module arrangement.

There is a need for a housing and a power semiconductor module arrangement comprising a housing that may be assembled in an effective and cost-efficient way.

### SUMMARY

The invention is set out in the appended set of claims.

The invention may be better understood with reference to the following drawings and the description. The components in the figures are not necessarily to scale, emphasis instead being placed upon illustrating the principles of the invention.

Moreover, in the figures, like referenced numerals designate corresponding parts throughout the different views.

### BRIEF DESCRIPTION OF THE DRAWINGS

Figure 1 is a cross-sectional view of a semiconductor module in which the housing is glued to the substrate. Figure 1 does not fall within the scope of the invention.
Figure 2 is a cross-sectional view of a semiconductor module comprising a housing according to embodiments of the disclosure.
Figure 3 is a top view of a semiconductor module comprising a housing according to embodiments of the disclosure, during assembly of the semiconductor module.
Figure 4 schematically illustrates a cross-sectional view of a section of a semiconductor module according to embodiments of the disclosure.
Figure 5, including Figures 5A and 5B, schematically illustrates a cross-sectional view (Figure 5A) and a top view (Figure 5B) of a section of a semiconductor module according to embodiments of the disclosure.
Figure 6, including Figures 6A and 6B, schematically illustrates cross-sectional views of a section of a semiconductor module according to embodiments of the disclosure.
Figure 7, schematically illustrates a three-dimensional view of a semiconductor module comprising a housing according to embodiments of the disclosure.
Figure 8 schematically illustrates a top view of a semiconductor module comprising a housing according to embodiments of the disclosure.
Figure 9, including Figures 9A and 9B, schematically illustrates a top view (Figure 9A) of a semiconductor module and a three-dimensional cross-sectional view (Figure 9B) of a section of a semiconductor module according to embodiments of the disclosure.
Figure 10 is a top view of a semiconductor module comprising a housing according to further embodiments of the disclosure, during assembly of the semiconductor module.
Figure 11 is a top view of a semiconductor module comprising a housing according to even further embodiments of the disclosure, during assembly of the semiconductor module.
Figure 12 is a top view of a semiconductor module comprising a housing according to even further embodiments of the disclosure, during assembly of the semiconductor module Figures 2 - 12 fall within the scope of the invention.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

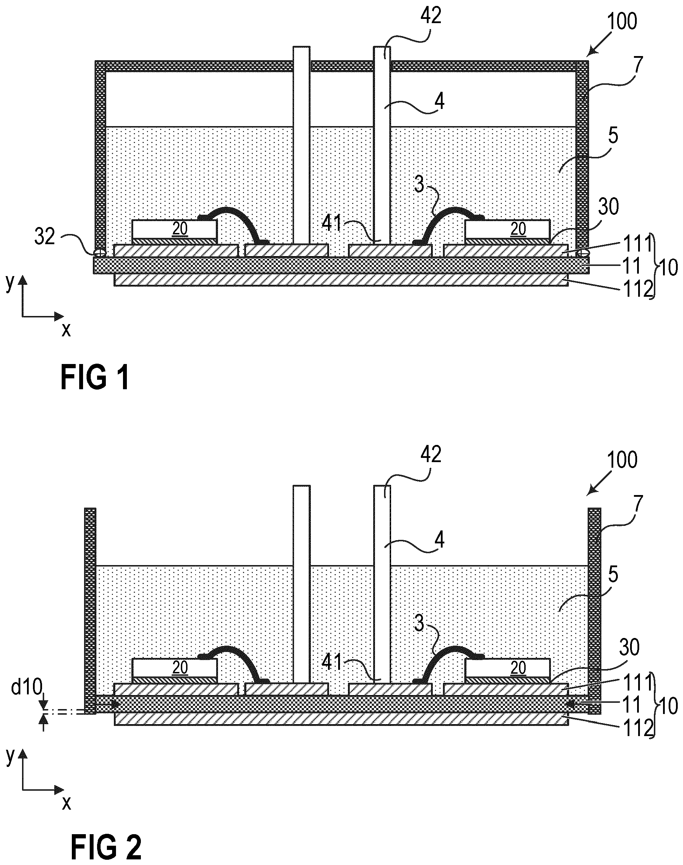

Referring to Figure 1, a cross-sectional view of a semiconductor module 100 not falling within the scope of the invention is illustrated. The semiconductor module 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 forms a base surface of the housing 7, while the housing 7 itself solely comprises sidewalls and a cover. In some power semiconductor module arrangements 100, more than one substrate 10 is arranged within the same housing 7.

One or more semiconductor bodies 20 may be arranged on the substrate 10. Each of the semiconductor bodies 20 arranged on the substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable or non-controllable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes four different sections. Different semiconductor bodies 20 may be mounted to the same or to different sections of the first metallization layer 111. Different sections of the first metallization layer may have no electrical connection or may be electrically connected to one or more other sections using, e.g., bonding wires 3. Electrical connections 3 may also include connection plates or conductor rails, for example, to name just a few examples. The one or more semiconductor bodies 20 may be electrically and mechanically connected to the substrate 10 by an electrically conductive connection layer 30. Such an electrically conductive connection layer may be a solder layer, a layer of an electrically conductive adhesive, or a layer of a sintered metal powder, e.g., a sintered silver powder, for example.

The semiconductor module 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of the terminal elements 4 protrudes out of the housing 7. The terminal elements 4 may be electrically contacted from the outside at their second end 42. The terminal elements 4 illustrated in Figure 1, however, are only examples. Terminal elements 4 may be implemented in any other way and may be arranged at any other position. For example, one or more terminal elements 4 may be arranged close to or adjacent to the sidewalls of the housing 7. Any other suitable implementation is possible. The terminal elements 4 may consist of or include a metal such as copper, aluminum, gold, silver, or any alloys thereof, for example. The terminal elements 4 may be electrically and mechanically connected to the substrate 10 by an electrically conductive connection layer (not specifically illustrated for the terminal elements 4). Such an electrically conductive connection layer generally may be a solder layer, a layer of an electrically conductive adhesive, or a layer of a sintered metal powder, e.g., a sintered silver powder, for example. According to other examples, terminal elements 4 may be inserted into hollow sleeves which are attached to the substrate 10 (sleeves not specifically illustrated in Figure 1).

Conventional semiconductor modules 100 generally further include an encapsulant or casting compound 5. The casting compound 5 may consist of or include a cured silicone gel or may be a rigid molding compound, for example. The casting compound 5 may at least partly fill the interior of the housing 7, thereby covering the components and electrical connections that are arranged on the substrate 10. The terminal elements 4 may be partly embedded in the casting compound 5. At least their second ends 42, however, are not covered by the casting compound 5 and protrude from the casting compound 5 through the housing 7, to the outside of the housing 7. The casting compound 5 is configured to protect the components and electrical connections inside the semiconductor module 100, in particular inside the housing 7, from certain environmental conditions and mechanical damage.

The housing 7 may be glued to the substrate 10 in order to remain in a desired position with respect to the substrate 10. A glued joint 32 (layer of glue) between the housing 7 and the substrate 10 is often sufficient to hold the housing 7 in its desired position with regard to the substrate 10. Gluing the housing 7 to the substrate 10, however, requires additional pretreatment steps (e.g., a plasma treatment of the substrate 10), a step in which the glue is applied to the substrate 10, as well as a hardening step in which the originally viscous glue is hardened, thereby attaching the housing 7 to the substrate 10. Each additional step during the assembly process requires additional process time and increases the overall cost of the power semiconductor module arrangement 100.

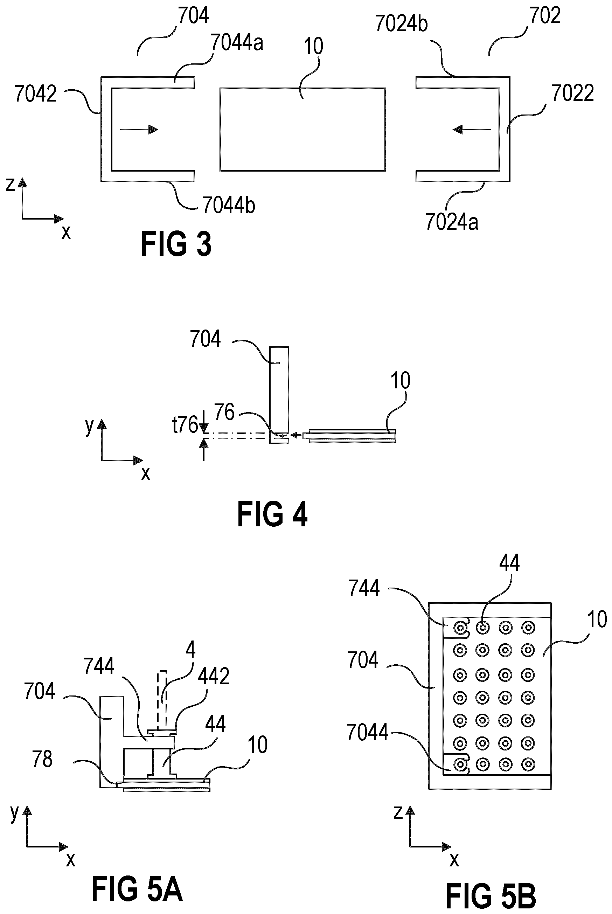

Now referring to Figure 2, a cross-sectional view of a power semiconductor module arrangement 100 according to embodiments of the disclosure and falling within the scope of the claims is schematically illustrated. The housing 7, instead of gluing it to the substrate 10, is arranged to surround and clamp the substrate 10 from all sides. That is, the housing 7 forms a closed frame around the substrate 10 and exerts pressure on at least some of a plurality of side surfaces of the substrate 10 along the circumference of the substrate 10. A top surface of the substrate 10 is a surface to which the semiconductor bodies 20 are mounted, and a bottom surface of the substrate 10 is a surface opposite the top surface and facing away from the semiconductor bodies 20. Side surfaces are surfaces of the substrate extending from the top surface to the bottom surface. While, in an assembled state of the housing 7 and the power semiconductor module arrangement 100, the housing 7 forms a closed frame around the substrate 10, in its unassembled state it comprises a first housing member 702 and a second housing member 704 which are separate and distinct from each other. This is schematically illustrated in the top view of Figure 3.

During assembly of the housing 7, the housing 7 is arranged to surround the substrate 10. Arranging the housing 7 to surround the substrate 10 comprises moving the first housing member 702 and the second housing member 704 towards each other, with the substrate 10 arranged between the first housing member 702 and the second housing member 704. This is schematically illustrated by means of the arrows in Figure 3. The substrate 10 is arranged between the first housing member 702 and the second housing member 704 such that a first side surface faces towards the first housing member 702 and a second side surface opposite the first side surface faces towards the second housing member 704. When the first housing member 702 and the second housing member 704 are in direct contact with each other, the first housing member 702 is attached to the second housing member 704 such that the first and second housing members 702, 704 form a closed frame around the substrate 10 and exert pressure on at least some of the side surfaces of the substrate 10 along the circumference of the substrate 10.

In the example illustrated in Figure 3, each of the first housing member 702 and the second housing member 704 comprises a base portion 7022, 7042, a first arm 7024a, 7044a extending from a first end of the respective base portion 7022, 7024, and a second arm 7024b, 7044b extending from a second end of the respective base portion 7022, 7042, wherein the first arm 7024a of the first housing member 702 is configured to be coupled to the second arm 7044b of the second housing member 704, and the second arm 7024b of the first housing member 702 is configured to be coupled to the first arm 7044a of the second housing member 704. That is, the first housing member 702 and the second housing member 704 in this example each are generally U-shaped. The base portions 7022, 7024 each form one of the side surfaces of the housing 7 in its assembled state. The first arm 7024a of the first housing member 702 together with the second arm 7044b of the second housing member 704, as well as the second arm 7024b of the first housing member 702 together with the first arm 7044a of the second housing member 704 form further side surfaces of the housing 7 in the assembled state. This, however, is only an example.

It is generally also possible, for example, that the first housing member 702 only comprises the base portion 7022, while the second housing member 704 comprises the base portion 7042, the first arm 7044a, and the second arm 7044b, wherein the first and second arms 7044a, 7044b of the second housing member 704 are configured to be directly coupled to the base portion 7022 of the first housing member 702. According to even further examples, each of the first housing member 702 and the second housing member 704 may comprise the respective base portion 7022, 7042 and the first arm 7024a, 7044a. That is, the first housing member 702 and the second housing member 704 may generally be L-shaped. The first arm 7024a of the first housing member 702 in this example may be configured to be directly coupled to the base portion 7042 of the second housing member 704. Similarly, the first arm 7044a of the second housing member 704 may be configured to be directly coupled to the base portion 7022 of the first housing member 702. Alternatively, any other suitable implementations are generally possible.

The closed frame formed by the first housing member 702 and the second housing member 704 comprises a mounting section for mounting the housing 7 to the substrate 10. This mounting section may be arranged at a defined distance d10 from a lower end of the first and second housing members 702, 704. The lower end of the first and second housing members 702, 704 is opposite an upper end of the first and second housing members 702, 704, wherein a lid or cover of the housing 7 may be attached to the upper end of the first and second housing members 702, 704, for example.

As the closed frame that is formed by the first housing member 702 and the second housing member 704 exerts a certain pressure on at least some of a plurality of side surfaces of the substrate 10 along the circumference of the substrate 10 (indicated by means of arrows in Figure 2), the substrate 10 is held in a desired position with respect to the housing 7. The pressure that can be exerted on the substrate 10 by means of the housing 7, however, may be limited. That is, there is a risk that clamping the substrate 10 between the first housing member 702 and the second housing member 704 is not sufficient to permanently hold the substrate 10 in its desired position with respect to the housing 7.

The housing 7, therefore, comprises a holding mechanism configured to prevent a substrate 10 arranged within the closed frame formed by the first housing member 702 and the second housing member 704 from shifting out if its desired position or even falling out of the housing 7. Such a holding mechanism may generally be implemented in any suitable way. Several possible examples of different holding mechanisms will be described in the following by means of Figures 4, 5 and 6.

According to some embodiments falling within the scope of the claims, the holding mechanism comprises a groove extending along an inside of the closed frame formed by the first housing member 702 and the second housing member 704. In the embodiment illustrated in Figure 4, the groove is implemented as a channel 76. The channel 76 may have a thickness t76 in a vertical direction y that is similar to the dimensions (i.e. thickness) of a substrate 10 (e.g., thickness of dielectric insulation layer 11) in the same direction. The channel 76 may extend along at least one of the sidewalls of the housing 7 in the assembled state. According to one example, the channel 76 is a continuous channel extending around the entire inner circumference of the housing 7. The substrate 10 may slide into the channel 76 during assembly of the housing 7, as is indicated by means of an arrow in Figure 4. In this way, the substrate 10 may be prevented from moving vertically, when the housing 7 is arranged to surround the substrate 10. The channel 76 prevents movements of the substrate 10 both in an upwards as well as a downwards direction.

The channel 76, however, is not necessarily required to continuously extend around the inner circumference of the housing 7 in its assembled state. According to other examples, the channel 76 may have two or more separate sections. For example, a first section may extend along a first sidewall of the housing 7 (e.g., along the base portion 7022 of the first housing member 702), and a second section may extend along a second sidewall of the housing 7 that is opposite the first sidewall (e.g., along the base portion 7042 of the second housing member 704). It may be sufficient that two opposite ends of the substrate 10 be arranged in different sections of the channel 76, for example, in order to hold the substrate 10 in its desired position.

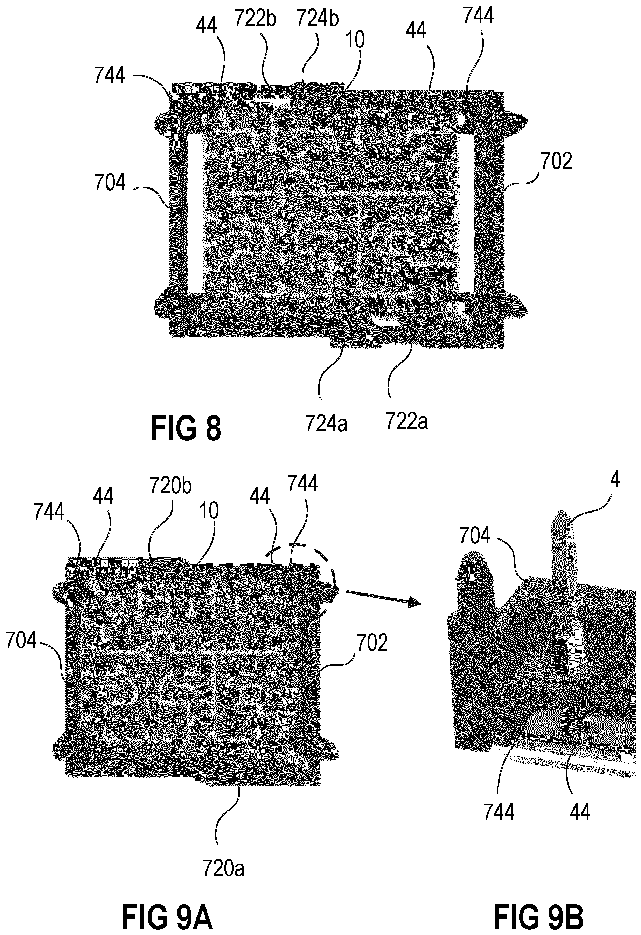

Now referring to Figures 5A and 5B, the holding mechanism, instead of or in addition to a groove, may comprise one or more gripping elements 744 attached to the first housing member 702 and/or the second housing member 704 and configured to engage with a corresponding counter element attached to the substrate 10. According to one example, the holding mechanism comprises four gripping elements 744, as is schematically illustrated in Figures 8 and 9A, for example. That is, one gripping element 744 may be arranged in each of the four corners of a rectangular or square semiconductor module 100, for example. It may, however, also be sufficient if the holding mechanism comprised of only two gripping elements 744 arranged on opposing sides of the housing 7, for example. Any other number of gripping elements 744 is generally possible. In some semiconductor modules, a single holding element 744 (exactly one) may be sufficient. The number of gripping elements 744 may depend on the size of the housing 7 and the size of the substrate 10 that is to be arranged in the housing 7. The larger the housing 7 and the substrate 10, the more gripping elements 744 may be required in order to prevent the substrate 10 from shifting out of its desired position, for example. If the gripping elements 744 are combined with other kinds of holding mechanisms (e.g., the channel 76 of Figure 4), a smaller number of gripping elements 744 may be needed.

Each gripping element 744 may have a fork-like geometry, as is exemplarily illustrated in the top view of Figure 5B, for example. Each gripping element 744 may be configured to clasp or engage with a corresponding counter element attached to the substrate 10. The counter element may be a dedicated component which has no other function than providing a counter element for the gripping element 744. It is, however, also possible that an element which has a different function in the power semiconductor module also functions as a counter element.

According to one example, the counter element comprises a sleeve 44 having a collar 442 formed at an end of the sleeve 44 that faces away from the substrate 10. The gripping element 744 with its fork-like geometry may be configured to clasp the sleeve 44 in a section directly adjacent to the collar 442 between the collar and the substrate 10 (see, e.g., Figure 5A). The collar 442 may have a diameter that is larger than a diameter of the fork-like gripping element 744. In this way, the substrate 10 may be prevented from unintentionally sliding out of the housing 7, as the collar 442 will not be able to slide through the gripping element 744.

The sleeve 44, as has been described above, may be a dedicated element that merely functions as a counter element for the gripping element 744. Sleeves, however, are often used in semiconductor modules 100, e.g., for attaching terminal elements 4 to a substrate 10. A terminal element 4 inserted into the sleeve 44 is schematically illustrated in dashed lines in Figure 5A. That is, a terminal element 4 may be inserted into a sleeve 44, the sleeve 44 providing a mechanical and electrical connection between the terminal element 4 and the substrate 10. Using a sleeve 44 or any other component that is already present on the substrate 10 for other reasons as a counter element has the advantage that no additional space is required on the substrate 10 for providing counter elements. The gripping elements 744 may be configured to clasp or engage with any other element that is present on the substrate 10 and that is suitable to be clasped instead of a sleeve 44. A connection between the one or more gripping elements 744 and the corresponding counter elements may be easily formed while attaching the first housing member 702 and the second housing member 704 to each other, with a substrate 10 with counter elements arranged thereon arranged in between.

In the example illustrated in Figure 5A, the second housing member 704 comprises a groove which, instead of as a channel, is implemented as a depression 78 (or step) formed at a lower end of the second housing member 704. A depression 78 may be similarly formed at a lower end of the first housing member 702. The depression 78 prevents the substrate 10 from unintentionally sliding into the housing 7 in the vertical direction y. At the same time, pressure is exerted on the respective side surface of the substrate 10 in a horizontal direction x that is perpendicular to the vertical direction y. In this way, the substrate 10 is securely held in its desired position and cannot move in a horizontal plane nor towards the inside of the housing 7 in the vertical y direction y.

The difference between the channel 76 as illustrated in Figure 4 and the depression 78 as illustrated in Figure 5A can be seen in that a channel 76 contacts the substrate 10 from above, from below, and from the side and, therefore, a movement of the substrate 10 in all directions in space can be prevented when the substrate 10 is arranged in its final mounting position within the housing 7. A depression 78 only contacts the substrate 10 from above and from the side. Therefore, a movement of the substrate 10 can be prevented in most, but not all directions in space. In particular, the depression 78 does not prevent the substrate 10 from moving out of the housing 7 in a vertical direction y.

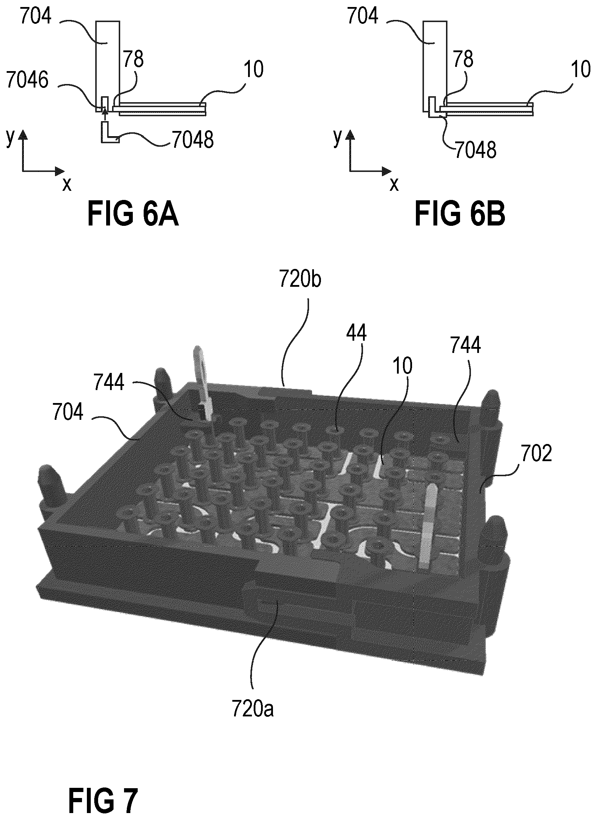

Now referring to Figures 6A and 6B, an even further example of a holding mechanism is schematically illustrated. In this example, the second housing member 704 (as well as the first housing member 702 which, however, is not explicitly illustrated in Figures 6A and 6B) comprises a depression 78, similar to what has been described with respect to Figure 5 above. By means of the depression 78, the substrate 10 is prevented from unintentionally moving in a horizontal plane as well as in the vertical direction y towards the inside of the housing 7. In order to also prevent the substrate 10 from unintentionally sliding vertically out of the housing 7, the first housing member 702 and/or the second housing member 704 may further comprise one or more indentations 7046 extending vertically into the respective housing member from its bottom end. The holding mechanism in this example further comprises one or more plug-in elements 7048, each of the one or more plug-in elements 7048 comprising a first section configured to be inserted into one of the one or more indentations 7046, and a second section configured to press the substrate 10, which is arranged in the depression 78 and between the second section of the plug-in element 7048 and the housing 7, towards the housing 7. Figure 6A illustrates the plug-in element 7048 in an unmounted state, and Figure 6B illustrates the plug-in element 7048 in a mounted state. As can be seen, in the mounted state the plug-in element 7048 together with the depression 78 forms a channel, similar to what has been described with respect to Figure 4 above. In the example illustrated in Figure 6, the plug-in element 7948 is generally L-shaped. A plug-in element 7048, however, may have any other suitable shape instead.

Generally, the first housing member 702 is attached to the second housing member 704 in any suitable way. According to one example, the first housing member 702 may be attached to the second housing member 704 by means of a glued or a welded connection. Gluing or welding the housing members 702, 704 to each other, however, requires additional steps for forming the connection. According to another example, therefore, the first housing member 702 and the second housing member 704, in the assembled state of the housing 7, are attached to each other by means of a first snap-fit connection 720a and a second snap-fit connection 720b. This is schematically illustrated in Figures 7, 8 and 9A, for example. The first snap-fit connection 720a may comprise a first snap-joint 722a attached to or integrally formed with the first housing member 702, and a first mating component 724a attached to or integrally formed with the second housing member 704, wherein the first snap-joint 722a and the first mating component 724a are configured to engage with each other to form the first snap-fit connection 720a. The second snap-fit connection 720b may comprise a second snap-joint 722b attached to or integrally formed with the second housing member 704, and a second mating component 724b attached to or integrally formed with the first housing member 702, wherein the second snap-joint 722b and the second mating component 724b are configured to engage with each other to form the second snap-fit connection 720b.

As can be seen in Figure 8, for example, the first snap-joint 722a may be attached to or integrally formed at an end of the first arm 7024a of the first housing member 702, and the first mating component 724a may be attached to or integrally formed at an end of the second arm 7044b of the second housing member 704. Similarly, the second snap-joint 722b may be attached to or integrally formed at an end of the first arm 7044a of the second housing member 704, and the second mating component 724b may be attached to or integrally formed at an end of the second arm 7024b of the first housing member 702. When the first housing member 702 and the second housing member 704 are moved towards each other during assembly of the power semiconductor module arrangement, the snap-joints 722a, 722b may easily engage with the respective mating components 724a, 724b. Snap-fit connections 720a, 720b are generally known and can be implemented in many different suitable ways. Most snap-fit connections generally have in common that they can be easily formed without much effort, but cannot be easily disengaged again. Some snap-fit connections are even permanent and cannot be disengaged without damaging the elements of the snap-fit connection. Most snap-fit connections, however, generally can be disengaged, but a certain amount of force is required to do so. If a snap-fit connection 720a, 720b that is used to attach the first housing member 702 and the second housing member 704 to each other is not deliberately opened, the probability of the snap-fit connection 720a, 720b unintentionally disengaging during the handling and normal operation of the power semiconductor module arrangement is generally towards zero.

Figure 7 illustrates a three-dimensional view of a semiconductor module according to embodiments of the disclosure in a mounted state of the housing 7. Exemplary snap-fit connections 720a, 720b, are schematically illustrated in greater detail therein. As has been mentioned above, however, the snap-fit connections 720a, 720b can be implemented in any other suitable way and are not restricted to the specific geometry that is exemplarily illustrated in Figure 7. Figure 8 schematically illustrates a top view of the semiconductor module of Figure 7 in an unmounted state. In the example illustrated in Figure 8, the snap-fit connections 720a, 720b have not yet been formed. Even further, the gripping elements 744 are not yet engaged with the corresponding counter elements (sleeves 44) on the substrate 10. Figure 9A schematically illustrates a top view of the arrangement of Figure 7 in its final mounting position. Figure 9B schematically illustrates in further detail in a three-dimensional cross-sectional view of a section of the semiconductor module a connection formed between a gripping element 744 and a corresponding counter element (i.e. sleeve 44) arranged on the substrate 10.

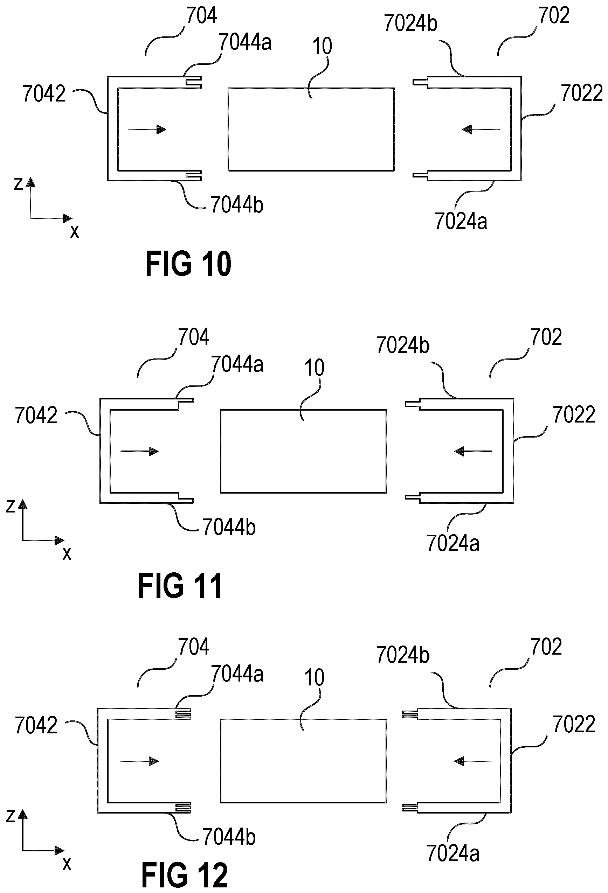

Now referring to Figures 10, 11, and 12, the snap-joints and mating components may have different shapes when seen from above. Figure 10 schematically illustrates snap-fit connections which may be referred to as "labyrinth design", for example. In this example, the snap-joints may have a fork like geometry, while the mating components may generally have the shape of a single finger, for example, which may engage with the fork-like snap-joints. In the example illustrated in Figure 11, the snap-joints and the mating components all have the shape of a single finger, which may be referred to as "single overlap design", for example. In the example illustrated in Figure 12, on the other hand, the snap-joints and the mating components all have a fork-like geometry, which may be referred to as "multi-tooth design", for example. In all examples, the first housing member 702 and the second housing member 704, in particular the snap-joints and corresponding mating components, overlap to a certain degree in their final mounting position. In the example illustrated in Figure 12 (multi-tooth design), a creepage distance in the area of the snap-fit connections between the inside and the outside of the housing 7, due to the double fork-like geometry (multi-tooth design), is significantly longer as compared to the single overlap design of Figure 11, for example. That is, a specific implementation of the snap-fit connections may be chosen based on requirements concerning creepage distances.

In the examples illustrated in Figures 10, 11, and 12, both snap-joints are attached to or integrally formed with the second housing member 704, and both mating components are attached to or integrally formed with the first housing member 702. This is generally possible. However, in these examples, the first housing member 702 and the second housing member 704 inevitably differ from each other. That is, during assembly of the housing 7, care must be taken that the correct elements, i.e. one first housing member 702 and one second housing member 704, are used. Even further, two different kinds of housing members need to be produced. That is, two different forms (e.g., molds) are required if, for example, the housing members 702, 704 are formed by means of molding methods. This can be avoided if the first housing member 702 and the second housing member 704 are identical to each other. The first housing member 702 and the second housing member 704 being identical to each other means that they have the same shape, the same dimensions, and are formed of the same material. In this way, the first housing member 702 may be readily replaced by a second housing member 704, and vice versa, resulting in the same housing 7. In other words, the identical first and second housing members 702 in the examples illustrated in Figures 7, 8, and 9A are rotationally symmetrical about an axis of rotation (axis of rotation not specifically illustrated in the figures).

## Claims

1. A housing (7) for a power semiconductor module arrangement (100) comprises:
a first housing member (702), a separate second housing member (704), and a holding mechanism, wherein
the first housing member (702) and the second housing member (704) are attached to each other and together form a closed frame,
the closed frame formed by the first housing member (702) and the second housing member (704) comprises a mounting section for mounting the housing (7) to a substrate (10) such that the closed frame extends around the substrate (10), wherein the mounting section is a region in which the substrate (10) contacts the housing (7),
the holding mechanism is configured to prevent the substrate (10) arranged within the closed frame formed by the first housing member (702) and the second housing member (704) from falling out of the housing (7),
the holding mechanism comprises a groove extending along an inside of the closed frame formed by the first housing member (702) and the second housing member (704), and
the groove is a channel (76) configured to contact the substrate (10) from above, from below, and from the side and preventing a movement of the substrate (10) in all directions in space, or the groove is a depression (78) configured to contact the substrate (10) from above and from the side and preventing a movement of the substrate (10) in most but not all directions in space.

2. The housing (7) of claim 1, wherein each of the first housing member (702) and the second housing member (704) comprises
a base portion (7022, 7042),
a first arm (7024a, 7044a) extending from a first end of the respective base portion (7022, 7024), and
a second arm (7024b, 7044b) extending from a second end of the respective base portion (7022, 7042), wherein
the first arm (7024a) of the first housing member (702) is configured to be coupled to the second arm (7044b) of the second housing member (704), and
the second arm (7024b) of the first housing member (702) is configured to be coupled to the first arm (7044a) of the second housing member (704).

3. The housing (7) of claim 1 or 2, wherein the holding mechanism comprises one or more gripping elements (744) attached to the first housing member (702) and/or the second housing member (704) and configured to engage with a corresponding counter element attached to the substrate (10).

4. The housing (7) of claim 3, wherein each gripping element (744) of the one or more the gripping elements (744) comprises a fork-like geometry.

5. The housing (7) of any of claims 1 to 4, wherein the first housing member (702) and/or the second housing member (704) comprise one or more indentations (7046), and the holding mechanism comprises one or more plug-in elements (7048), each of the one or more plug-in elements (7048) comprising a first section configured to be inserted into one of the one or more indentations (7046), and a second section configured to press a substrate (10) arranged between the second section and the respective housing member (702, 704) towards the housing (7).

6. The housing (7) of any of the preceding claims, wherein the first housing member (702) and the second housing member (704)are attached to each other by means of a first snap-fit connection (720a) and a second snap-fit connection (720b).

7. The housing (7) of claim 6, wherein
the first snap-fit connection (720a) comprises a first snap-joint (722a) attached to or integrally formed with the first housing member (702), and a first mating component (724a) attached to or integrally formed with the second housing member (704), wherein the first snap-joint (722a) and the first mating component (724a) are configured to engage with each other to form the first snap-fit connection (720a), and
the second snap-fit connection (720b) comprises a second snap-joint (722b) attached to or integrally formed with the second housing member (704), and a second mating component (724b) attached to or integrally formed with the first housing member (702), wherein the second snap-joint (722b) and the second mating component (724b) are configured to engage with each other to form the second snap-fit-connection (720b).

8. The housing (7) of any of the preceding claims, wherein the first housing member (702) and the second housing member (704) are identical to each other.

9. A power semiconductor module arrangement (100) comprises:
a housing (7) according to any of claims 1 to 8; and
a substrate (10), wherein
the housing (7) forms a closed frame around the substrate (10) and exerts pressure on at least some of a plurality of side surfaces of the substrate (10) along the circumference of the substrate (10).

10. The power semiconductor module arrangement (100) of claim 9, wherein the substrate (10) comprises one or more counter elements attached thereto, each counter element of the one or more counter elements being configured to engage with one of the one or more gripping elements (744) attached to the first housing member (702) and/or the second housing member (704).

11. The power semiconductor module arrangement (100) of claim 10, wherein each counter element of the one or more counter elements comprises a sleeve (44) having a collar (442) formed at an end of the sleeve (44) facing away from the substrate (10), and wherein each gripping element (744) of the one or more gripping elements comprises a fork-like geometry and is configured to clasp the sleeve (44) in a section directly adjacent to the collar (442) between the collar and the substrate (10).

12. A method for assembling a power semiconductor module arrangement (100) according to claims 9 - 11, the method comprising arranging a housing (7) according to any of claims 1 to 8 to surround a substrate (10), wherein arranging the housing (7) to surround the substrate (10) comprises
moving the first housing member (702) and the second housing member (704) towards each other, with the substrate (10) arranged between the first housing member (702) and the second housing member (704), and
attaching the first housing member (702) to the second housing member (704) such that the first and second housing members (702, 704) together form a closed frame around the substrate (10) and exert pressure on at least some of a plurality of side surfaces of the substrate (10) along the circumference of the substrate (10).

## Patentansprüche

1. Gehäuse (7) für eine Leistungshalbeitermodulanordnung (100), umfassend:
ein erstes Gehäuseelement (702), ein separates zweites Gehäuseelement (704) und einen Haltemechanismus, wobei
das erste Gehäuseelement (702) und das zweite Gehäuseelement (704) aneinander befestigt sind und zusammen einen geschlossenen Rahmen bilden,
der durch das erste Gehäuseelement (702) und das zweite Gehäuseelement (704) gebildete geschlossene Rahmen einen Montageabschnitt zum Montieren des Gehäuses (7) an einem Substrat (10) umfasst, so dass sich der geschlossene Rahmen um das Substrat (10) herum erstreckt, wobei der Montageabschnitt ein Gebiet ist, in dem das Substrat (10) das Gehäuse (7) kontaktiert,
der Haltemechanismus dazu ausgelegt ist, zu verhindern, dass das Substrat (10), das innerhalb des durch das erste Gehäuseelement (702) und das zweite Gehäuseelement (704) gebildeten geschlossenen Rahmens angeordnet ist, aus dem Gehäuse (7) heraus fällt,
der Haltemechanismus eine Nut umfasst, die sich entlang einer Innenseite des durch das erste Gehäuseelement (702) und das zweite Gehäuseelement (704) gebildeten geschlossenen Rahmens erstreckt, und
die Nut ein Kanal (76) ist, der dazu ausgelegt ist, das Substrat (10) von oben, von unten und von der Seite zu kontaktieren und eine Bewegung des Substrats (10) in allen Raumrichtungen zu verhindern, oder die Nut eine Vertiefung (78) ist, die dazu ausgelegt ist, das Substrat (10) von oben und von der Seite zu kontaktieren und eine Bewegung des Substrats (10) in den meisten, jedoch nicht allen Raumrichtungen zu verhindern.

2. Gehäuse (7) nach Anspruch 1, wobei sowohl das erste Gehäuseelement (702) als auch das zweite Gehäuseelement (704) Folgendes umfasst
einen Basisteil (7022, 7042),
einen ersten Arm (7024a, 7044a), der sich von einem ersten Ende des jeweiligen Basisteils (7022, 7024) erstreckt, und
einen zweiten Arm (7024b, 7044b), der sich von einem zweiten Ende des jeweiligen Basisteils (7022, 7042) erstreckt, wobei
der erste Arm (7024a) des ersten Gehäuseelements (702) dazu ausgelegt ist, mit dem zweiten Arm (7044b) des zweiten Gehäuseelements (704) gekoppelt zu sein, und
der zweite Arm (7024b) des ersten Gehäuseelements (702) dazu ausgelegt ist, mit dem ersten Arm (7044a) des zweiten Gehäuseelements (704) gekoppelt zu sein.

3. Gehäuse (7) nach Anspruch 1 oder 2, wobei der Haltemechanismus ein oder mehrere Greifelemente (744) umfasst, die an dem ersten Gehäuseelement (702) und/oder dem zweiten Gehäuseelement (704) befestigt und dazu ausgelegt sind, mit einem entsprechenden an dem Substrat (10) befestigten Gegenelement in Eingriff zu kommen.

4. Gehäuse (7) nach Anspruch 3, wobei jedes Greifelement (744) des einen oder der mehreren Greifelemente (744) eine gabelartige Geometrie umfasst.

5. Gehäuse (7) nach einem der Ansprüche 1 bis 4, wobei das erste Gehäuseelement (702) und/oder das zweite Gehäuseelement (704) eine oder mehrere Einkerbungen (7046) umfassen und der Haltemechanismus ein oder mehrere Steckelemente (7048) umfasst, wobei jedes des einen oder der mehreren Steckelemente (7048) einen ersten Abschnitt, der dazu ausgelegt ist, in eine der einen oder mehreren Einkerbungen (7046) eingesetzt zu sein, und einen zweiten Abschnitt umfasst, der dazu ausgelegt ist, ein Substrat (10), das zwischen dem zweiten Abschnitt und dem jeweiligen Gehäuseelement (702, 704) angeordnet ist, in Richtung des Gehäuses (7) zu drücken.

6. Gehäuse (7) nach einem der vorhergehenden Ansprüche, wobei das erste Gehäuseelement (702) und das zweite Gehäuseelement (704) mittels einer ersten Schnappverbindung (720a) und einer zweiten Schnappverbindung (720b) aneinander befestigt sind.

7. Gehäuse (7) nach Anspruch 6, wobei
die erste Schnappverbindung (720a) ein erstes Schnappverbindungsglied (722a), das an dem ersten Gehäuseelement (702) befestigt oder integral mit diesem ausgebildet ist, und eine erste Passkomponente (724a) umfasst, die an dem zweiten Gehäuseelement (704) befestigt oder integral mit diesem ausgebildet ist, wobei das erste Schnappverbindungsglied (722a) und die erste Passkomponente (724a) dazu ausgelegt sind, miteinander in Eingriff zu kommen, um die erste Schnappverbindung (720a) zu bilden, und
die zweite Schnappverbindung (720b) ein zweites Schnappverbindungsglied (722b), das an dem zweiten Gehäuseelement (704) befestigt oder integral mit diesem ausgebildet ist, und eine zweite Passkomponente (724b) umfasst, die an dem ersten Gehäuseelement (702) befestigt oder integral mit diesem ausgebildet ist, wobei das zweite Schnappverbindungsglied (722b) und die zweite Passkomponente (724b) dazu ausgelegt sind, miteinander in Eingriff zu kommen, um die zweite Schnappverbindung (720b) zu bilden.

8. Gehäuse (7) nach einem der vorhergehenden Ansprüche, wobei das erste Gehäuseelement (702) und das zweite Gehäuseelement (704) identisch zueinander sind.

9. Leistungshalbleitermodulanordnung (100), umfassend:
ein Gehäuse (7) nach einem der Ansprüche 1 bis 8; und
ein Substrat (10), wobei
das Gehäuse (7) einen geschlossenen Rahmen um das Substrat (10) herum bildet und Druck auf zumindest einige einer Mehrzahl von Seitenflächen des Substrats (10) entlang des Umfangs des Substrats (10) ausübt.

10. Leistungshalbleitermodulanordnung (100) nach Anspruch 9, wobei das Substrat (10) ein oder mehrere daran befestigte Gegenelemente umfasst, wobei jedes Gegenelement des einen oder der mehreren Gegenelemente dazu ausgelegt ist, mit einem des einen oder der mehreren an dem ersten Gehäuseelement (702) und/oder dem zweiten Gehäuseelement (704) befestigten Greifelemente (744) in Eingriff zu kommen.

11. Leistungshalbleitermodulanordnung (100) nach Anspruch 10, wobei jedes Gegenelement des einen oder der mehreren Gegenelemente eine Hülse (44) mit einem Kragen (442) umfasst, der an einem Ende der Hülse (44) gebildet ist, das von dem Substrat (10) abgewandt ist, und wobei jedes Greifelement (744) des einen oder der mehreren Greifelemente eine gabelartige Geometrie umfasst und dazu ausgelegt ist, die Hülse (44) in einem Abschnitt direkt angrenzend an den Kragen (442) zwischen dem Kragen und dem Substrat (10) zu ergreifen.

12. Verfahren zum Montieren einer Leistungshalbleitermodulanordnung (100) nach den Ansprüchen 9-11, wobei das Verfahren Anordnen eines Gehäuses (7) nach einem der Ansprüche 1 bis 8 derart, dass es ein Substrat (10) umgibt, umfasst, wobei das Anordnen des Gehäuses (7) derart, dass es ein Substrat (10) umgibt, Folgendes umfasst
Bewegen des ersten Gehäuseelements (702) und des zweiten Gehäuseelements (704) zueinander hin, wobei das Substrat (10) zwischen dem ersten Gehäuseelement (702) und dem zweiten Gehäuseelement (704) angeordnet wird, und
Befestigen des ersten Gehäuseelements (702) an dem zweiten Gehäuseelement (704), so dass das erste und das zweite Gehäuseelement (702, 704) zusammen einen geschlossenen Rahmen um das Substrat (10) herum bilden und Druck auf zumindest einige einer Mehrzahl von Seitenflächen des Substrats (10) entlang des Umfangs des Substrats (10) ausüben.

## Revendications

1. Un boîtier (7) d'un agencement (100) de module à semiconducteur de puissance comprend :
un premier élément (702) de boîtier, un deuxième élément (704) de boîtier distinct et un mécanisme de maintien, dans lequel
le premier élément (702) de boîtier et le deuxième élément (704) de boîtier sont fixés l'un à l'autre et forment ensemble un cadre fermé,
le cadre fermé formé par le premier élément (702) de boîtier et le deuxième élément (704) de boîtier comprend une partie de montage pour monter le boîtier (7) sur un substrat (10), de manière à ce que le cadre fermé s'étende autour du substrat (10), dans lequel la partie de montage est une région, dans laquelle le substrat (10) est en contact avec le boîtier (7),
le mécanisme de maintien est configuré pour empêcher le substrat (10) disposé dans le cadre fermé, formé par le premier élément (702) de boîtier et le deuxième élément (704) de boîtier, de tomber du boîtier (7),
le mécanisme de maintien comprend une rainure s'étendant le long d'une face intérieure du cadre fermé, formé par le premier élément (702) de boîtier et le deuxième élément (704) de boîtier, et
la rainure est un canal (76) configuré pour être en contact avec le substrat (10) par le dessus, par le dessous et par le côté et empêchant un mouvement du substrat (10) dans toutes les directions de l'espace, ou la rainure est une dépression (78) configurée pour être en contact avec le substrat (10) par le dessus et par le côté et empêchant un déplacement du substrat (10) dans la plupart mais non dans toutes les directions de l'espace.

2. Le boîtier (7) de la revendication 1, dans lequel chacun du premier élément (702) de boîtier et du deuxième élément (704) de boîtier comprend
une partie (7022, 7042) de base,
un premier bras (7024a, 7044a) s'étendant d'une première extrémité de la partie (7022, 7024) de base respective, et
un deuxième bras (7024b, 7044b) s'étendant d'une deuxième extrémité de la partie (7022, 7042) de base respective, dans lequel
le premier bras (7024a) du premier élément (702) de boîtier est configuré pour être accouplé au deuxième bras (7044b) du deuxième élément (704) de boîtier, et
le deuxième bras (7024b) du premier élément (702) de boîtier est configuré pour être accouplé au premier bras (7044a) du deuxième élément (704) de boîtier.

3. Le boîtier (7) de la revendication 1 ou 2, dans lequel le mécanisme de maintien comprend un ou plusieurs éléments (744) de prise fixés au premier élément (702) de boîtier et/ou au deuxième élément (704) de boîtier et configuré pour se prendre avec un élément antagoniste correspondant fixé au substrat (10).

4. Le boîtier (7) de la revendication 3, dans lequel chaque élément (744) de prise du un ou des plusieurs éléments (744) de prise comprend une géométrie fourchue.

5. Le boîtier (7) de l'une quelconque des revendications 1 à 4, dans lequel le premier élément (702) de boîtier et/ou le deuxième élément (704) de boîtier comprennent une ou plusieurs empreintes (7046), et le mécanisme de maintien comprend un ou plusieurs éléments (7048) d'enfichage, chacun des uns ou plusieurs éléments (7048) d'enfichage comprenant une première partie configurée pour être insérée dans l'une de la une ou des plusieurs empreintes (7046) et une deuxième partie configurée pour presser un substrat (10), mis entre la deuxième partie et l'élément (702, 704) de boîtier, vers le boîtier (7).

6. Le boîtier (7) de l'une quelconque des revendications précédentes, dans lequel le premier élément (702) de boîtier et le deuxième élément (704) de boîtier sont fixés l'un à l'autre au moyen d'une première connexion (720a) à déclic et d'une deuxième connexion (720b) à déclic.

7. Le boîtier (7) de la revendication 6, dans lequel
la première connexion (720a) à déclic comprend assemblage (722a) à déclic fixé au premier élément (702) de boîtier ou d'une pièce avec lui et un premier composant (724a) conjugué fixé au deuxième élément (704) de boîtier ou d'une pièce avec lui, dans lequel le premier assemblage (722a) à déclic et le premier composant (724a) conjugué sont configurés pour se prendre l'un avec l'autre afin de former la première connexion (720a) à déclic, et
la deuxième connexion (720b) à déclic comprend un deuxième assemblage (722b) à déclic fixé au deuxième élément (704) de boîtier ou d'une pièce avec lui et un deuxième composant (724b) conjugué fixé au premier élément (702) de boîtier ou d'une pièce avec lui, dans lequel le deuxième assemblage (722b) à déclic et le deuxième composant (724b) conjugué est configuré pour se prendre l'un avec l'autre afin de former la deuxième connexion (720b) à déclic.

8. Le boîtier (7) de l'une quelconque des revendications précédentes, dans lequel le premier élément (702) de boîtier et le deuxième élément (704) de boîtier sont identiques l'un à l'autre.

9. Un agencement (100) de module à semiconducteur de puissance comprend :
un boîtier (7) suivant l'une quelconque des revendications 1 à 8 ; et
un substrat (10), dans lequel
le boîtier (7) forme un cadre fermé autour du substrat (10) et applique de la pression à au moins certaines d'une pluralité de surfaces latérales du substrat (10) le long de la circonférence du substrat (10).

10. L'agencement (100) de module à semiconducteur de puissance de la revendication 9, dans lequel le substrat (10) comprend un ou plusieurs éléments antagonistes, qui y sont fixés, chaque élément antagoniste du un ou des plusieurs éléments antagonistes étant configuré pour se prendre avec l'un du un ou des plusieurs éléments (744) de prise fixés au premier élément (702) de boîtier et/ou au deuxième élément (704) de boîtier.

11. L'agencement (100) de module à semiconducteur de puissance de la revendication 10, dans lequel chaque élément antagoniste du un ou des plusieurs éléments antagonistes comprend un manchon (44) ayant un collet (442) formé à une extrémité du manchon (44) n'étant pas en face du substrat (10), et dans lequel chaque élément (744) de prise du un ou des plusieurs éléments de prise a une géométrie fourchue et est configuré pour serrer le manchon (44) dans une partie directement contiguë au collet (442) entre le collet et le substrat (10).

12. Un procédé d'assemblage d'un agencement (100) de module à semiconducteur de puissance suivant les revendications 9 à 11, le procédé comprenant mettre un boîtier (7) suivant l'une quelconque des revendications 1 à 8, de manière à ce qu'il entoure un substrat (10), dans lequel mettre le boîtier (7), de manière à ce qu'il entoure le substrat (10) comprend
déplacer le premier élément (702) de boîtier et le deuxième élément (704) de boîtier l'un vers l'autre, alors que le substrat (10) est disposé entre le premier élément (702) de boîtier et le deuxième élément (704) de boîtier, et
fixer le premier élément (702) de boîtier et le deuxième élément (704) de boîtier, de manière à ce que le premier et le deuxième éléments (702, 704) de boîtier forment ensemble un cadre fermé autour du substrat (10) et applique de la pression à au moins certaines d'une pluralité de surfaces latérales du substrat (10) le long de la circonférence du substrat (10).
